# EUROPEAN PATENT APPLICATION

(11) **EP 4 583 645 A1**
(43) Date of publication of application: **09.07.2025**
(21) Application number: 23860475.5
(22) Date of filing: 31.08.2023
(51) Int. Cl.: H05K 3/46

(54) **PRINTED WIRING BOARD AND METHOD FOR MANUFACTURING SAME**

(30) Priority: 31.08.2022 JP 2022137463
(71) Applicant: Kyocera Corporation, Kyoto-shi, Kyoto 612-8501 (JP)
(72) Inventor: SAEKI Shinri, Kyoto-shi, Kyoto 612-8501 (JP); ISHIOKA Takashi, Kyoto-shi, Kyoto 612-8501 (JP)
(74) Representative: Viering, Jentschura & Partner mbB Patent- und Rechtsanwälte
(86) International application number: PCT/JP2023/031794
(87) International publication number: WO 2024/048713

(57) **Abstract**

Provided are a printed wiring board including a via conductor less likely to be disengaged from an insulating layer, and a method of manufacturing the printed wiring board. The printed wiring board includes a core substrate and a buildup layer stacked on the core substrate. The buildup layer includes an insulating layer stacked on the core substrate, a hole penetrating the insulating layer in a thickness direction, and a via conductor filled in the hole. The via conductor has a columnar shape.

## Description

### TECHNICAL FIELD

The present disclosure relates to a printed wiring board and a method of manufacturing the printed wiring board.

### BACKGROUND OF INVENTION

A conventionally disclosed printed wiring board includes a buildup layer stacked on at least one surface of a core substrate (e.g., Patent Literature 1). The buildup layer is provided with a via conductor. The via conductor is connected to a plated wiring line on a surface of the core substrate and a plated wiring line on a surface of the buildup layer. These plated wiring lines are electrically conducted by the via conductor.

### CITATION LIST

### PATENT LITERATURE

Patent Literature 1: Japanese Unexamined Patent Application Publication No. 2017-084913

### SUMMARY

### PROBLEM TO BE SOLVED

Technical development has been recently promoted for a reduction in the thickness of printed wiring boards due to a reduction in the size of electronic devices. Also promoted are technical development for a reduction in the thickness of buildup layers as well as technical development for a reduction in the diameter of via conductors. A buildup layer having a small thickness and a via conductor having a small diameter decrease a contact area between the via conductor and a surrounding insulating layer as well as a contact area between the via conductor and a plated wiring line. The via conductor is thus likely to be disengaged from the insulating layer in this configuration.

### SOLUTION TO PROBLEM

In an aspect of the present disclosure, a printed wiring board includes a core substrate and a buildup layer stacked on the core substrate. The buildup layer includes an insulating layer stacked on the core substrate, a hole penetrating the insulating layer in a thickness direction, and a via conductor filled in the hole. The via conductor has a columnar shape.

In an aspect of the present disclosure, a method of manufacturing a printed wiring board includes: preparing a stacked body including a core substrate and a buildup precursor layer that includes an insulating layer and a seed layer made of a metal in a mentioned order and that is overlapped with the core substrate; disposing, above and adjacent to the seed layer in the stacked body, a first mask including a first through-hole, and applying a first laser beam to the seed layer through the first through-hole to form an opening in the seed layer; disposing, on the seed layer at a position above the first through-hole, a second mask including a second through-hole smaller in diameter than the first through-hole, and applying a second laser beam to the insulating layer through the opening to form a hole in the insulating layer; and applying plating treatment to the insulating layer provided with the hole to grow a plated film on the seed layer and the hole and form a via conductor and a top layer.

### ADVANTAGEOUS EFFECT

According to the present disclosure, a via conductor is less likely to be disengaged from an insulating layer.

### BRIEF DESCRIPTION OF THE DRAWINGS

FIG. 1 is a sectional view of a printed wiring board.
FIG. 2 is an enlarged view of a region II in FIG. 1.
FIG. 3 is an enlarged sectional view of a boundary between an outer circumference of a via conductor and an inner circumference of a hole.
FIG. 4 is an enlarged sectional view of another boundary between the outer circumference of the via conductor and the inner circumference of the hole.
FIG. 5 is an enlarged sectional view a via conductor according to a variation.
FIG. 6 is a sectional view of a stacked body in a process of manufacturing a printed wiring board.
FIG. 7 is a sectional view of the stacked body in a process subsequent to the process in FIG. 6.
FIG. 8 is a sectional view of the stacked body in a process subsequent to the process in FIG. 7.
FIG. 9 is a sectional view of the stacked body in a process subsequent to the process in FIG. 8.
FIG. 10 is a sectional view of the stacked body in a process subsequent to the process in FIG. 9.
FIG. 11 is a sectional view of the stacked body in a process subsequent to the process in FIG. 10.
FIG. 12 is a sectional view of the stacked body in a process subsequent to the process in FIG. 11.
FIG. 13 is a sectional view of the stacked body in a process subsequent to the process in FIG. 12.

### DESCRIPTION OF EMBODIMENTS

An embodiment will be described hereinafter with reference to the drawings. The drawings to be referred to hereinafter illustrate only simplified principal members necessary for description of the embodiment for convenience of the description. Accordingly, the present disclosure provides a printed wiring board 1 that may include any appropriate constituent member not illustrated in the drawings. Furthermore, members illustrated in the drawings do not accurately indicate sizes, size ratios, or the like of actual constituent members.

### [1. Printed wiring board]

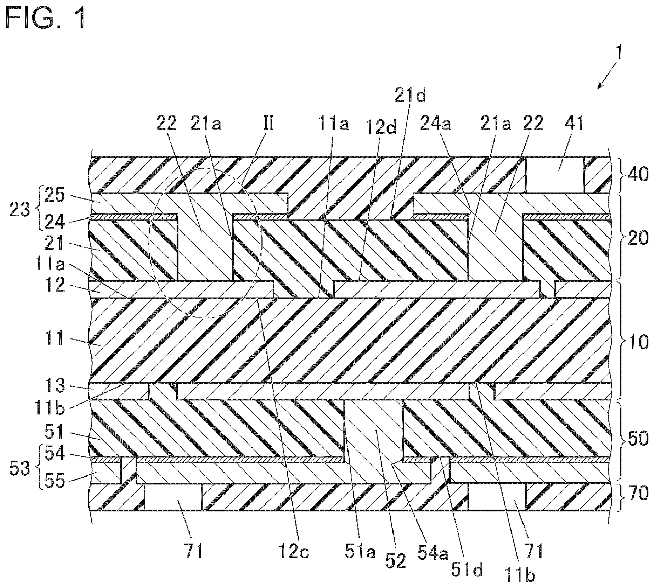

Description is made to the printed wiring board 1 with reference to FIG. 1.

The printed wiring board 1 is a multilayer substrate. The printed wiring board 1 includes a core substrate 10 and a first buildup layer 20. As illustrated in FIG. 1, the printed wiring board 1 includes a first solder resist layer 40, a second buildup layer 50, and a second solder resist layer 70 as necessary. The second solder resist layer 70, the second buildup layer 50, the core substrate 10, the first buildup layer 20, and the first solder resist layer 40 may be stacked in the mentioned order.

### [1-1. Core substrate]

The core substrate 10 includes a base 11 and conductor layers 12 and 13.

The base 11 is formed into a flat plate shape. The base 11 includes a first surface 11a and a second surface 11b opposite to the first surface 11a. The first surface 11a and the second surface 11b are directed in opposite directions. The base 11 has a thickness from the first surface 11a to the second surface 11b. A direction from the first surface 11a to the second surface 11b and an opposite direction thereof correspond to a thickness direction.

The base 11 is made of an insulating material. Examples of such an insulating material include organic resins such as epoxy resin, bismaleimide triazine resin, polyimide resin, polyphenylene ether (PPE) resin, polyphenylene oxide (PPO) resin, cyanate ester resin, and a liquid crystal polymer. The insulating material may include two or more of these organic resins mixed together. One, or two or more of these organic resins may be blended with a reinforcer. Examples of the reinforcer include fabric materials such as glass fiber, glass nonwoven fabric, aramid fiber, aramid nonwoven fabric, polyester fiber, and polyester nonwoven fabric. One, or two or more of these organic resins may contain an inorganic filler such as barium sulfate, talc, clay, glass, calcium carbonate, or titanium.

The conductor layer 12 is stacked on the first surface 11a of the base 11. The conductor layer 13 is stacked on the second surface 11b of the base 11. The conductor layers 12 and 13 constitute a wiring pattern. The conductor layers 12 and 13 are each made of a conductive metal such as copper. Each of the conductor layers 12 and 13 is made of a plated metal such as plated copper. Each of the conductor layers 12 and 13 is preferably 18 µm or more and 100 µm or less in thickness.

The core substrate 10 may have a multilayer structure. The multilayer structure can have a following exemplary aspect. For example, the multilayer structure includes a plurality of insulating layers, one or a plurality of internal conductor layers, and two surface conductor layers. The insulating layers are stacked in sequence. The internal conductor layer is interposed between the insulating layers. The two surface conductor layers are stacked respectively on two uppermost surfaces of a stacked body including the plurality of insulating layers identically or similarly to the conductor layers 12 and 13 stacked respectively on the surfaces 11a and 11b of the base 11. The internal conductor layer and the surface conductor layers constitute a wiring pattern.

### [1-2. buildup layer]

The first buildup layer 20 includes an insulating layer 21, at least one via conductor 22, and a surface conductor layer 23.

The insulating layer 21 is stacked on a surface of the core substrate 10. That is, the insulating layer 21 covers the conductor layer 12 as well as the first surface 11a of the base 11. In other words, the core substrate 10 includes the conductor layer 12 stacked on the surface in contact with the buildup layer 20. The insulating layer 21 is exemplarily 40 µm to 100 µm in thickness, that is, a thickness from a surface 12d of the conductor layer 12 opposite to a surface 12c of the conductor layer 12 in contact with the first surface 11a to a surface 21d of the insulating layer 21 on a side far from the core substrate 10.

The insulating layer 21 is made of an insulating material. Examples of such an insulating material include organic resins such as epoxy resin, bismaleimide triazine resin, polyimide resin, polyphenylene ether (PPE) resin, polyphenylene oxide (PPO) resin, cyanate ester resin, polytetrafluoroethylene (PTFE) resin, and a liquid crystal polymer. The insulating material may include two or more of these organic resins mixed together. One, or two or more of these organic resins may be blended with a reinforcer. Examples of the reinforcer include fabric materials such as glass fiber, glass nonwoven fabric, aramid fiber, aramid nonwoven fabric, polyester fiber, and polyester nonwoven fabric. One, or two or more of these organic resins may contain an inorganic filler such as barium sulfate, talc, clay, glass, calcium carbonate, or titanium.

The via conductor 22 penetrates the insulating layer 21 in a thickness direction. Specifically, the insulating layer 21 includes at least one hole 21a penetrating the insulating layer 21 in the thickness direction such that the via conductor 22 is filled in each of the holes 21a. The via conductor 22 is made of a conductive metal such as copper. The via conductor 22 is coupled and electrically connected to the conductor layer 12 of the core substrate 10.

When a plurality of via conductors 22 is provided, these via conductors 22 disposed to have a pitch of 245 µm can still secure sufficient insulation characteristics.

The buildup layer 20 may optionally include a seed layer 24 interposed between the insulating layer 21 and a top layer 25. The seed layer 24 preferably has conductivity. The seed layer 24 is preferably a metal film.

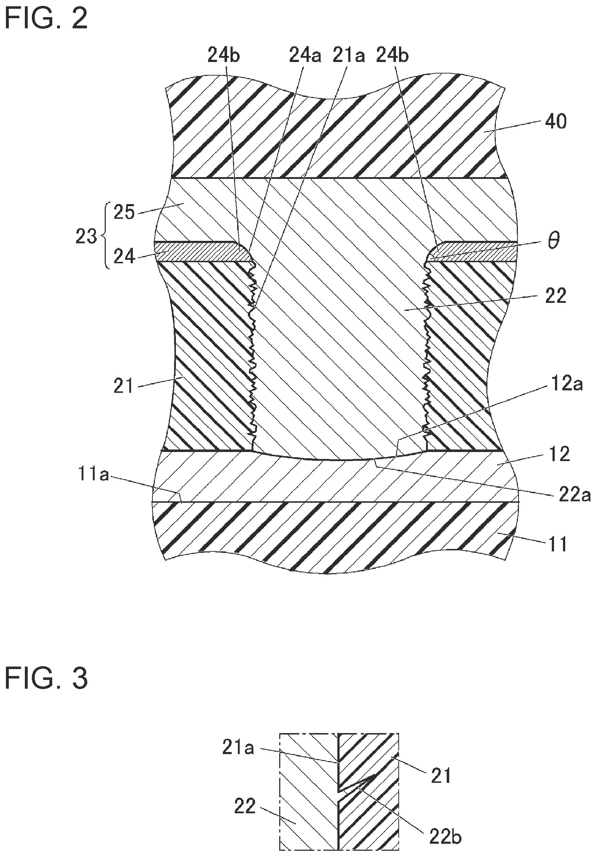

FIG. 2 is an enlarged view of a region II indicated in FIG. 1. As illustrated in FIG. 2, the conductor layer 12 includes portion being in contact with the via conductor 22 and including a surface 12a that may have a concave surface shape. That is, when the conductor layer 12 includes such a concave portion in contact with the via conductor 22, the concave portion receives a bottom 22a of the via conductor 22. This configuration increases a contact area between the conductor layer 12 and the via conductor 22. This can increase bonding force between the conductor layer 12 and the via conductor 22. The via conductor 22 includes an end surface adjacent to the conductor layer 12 and preferably having a convex surface shape. The bottom 22a of the via conductor 22 is thus fitted to the surface 12a in the concave surface shape.

As illustrated in FIG. 1, the via conductor 22 is macroscopically formed into a columnar shape surrounding a central axis in the thickness direction of the insulating layer 21. A columnar shape herein indicates a shape having a constant diameter of the via conductor 22 in the thickness direction. The via conductor 22 is in contact with an inner wall surface of the hole 21a entirely in the thickness direction. As illustrated in FIG. 2, the inner wall surface of the hole 21a microscopically is formed to have unevenness, and the via conductor 22 is tightly filled in the unevenness on the inner wall surface of the hole 21a entirely in the thickness direction. That is, the via conductor 22 is formed to have unevenness that is tightly engaged with the unevenness on the inner wall surface of the hole 21a.

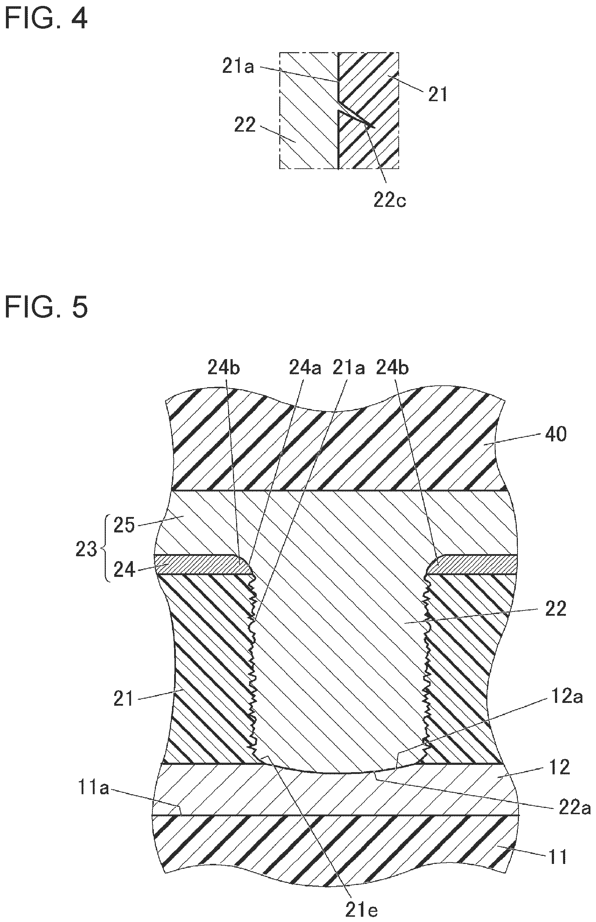

FIGs. 3 and 4 are enlarged sectional views of a boundary between the via conductor 22 and the inner wall surface of the hole 21a. FIG. 4 illustrates a portion located differently from a portion illustrated in FIG. 3. As illustrated in FIGs. 3 and 4, the unevenness of the via conductor 22 includes at least one protrusion 22b and at least one protrusion 22c. The protrusions 22b and 22c project radially outward and stick into the insulating layer 21. In other words, the protrusions 22b and 22c project radially outward. Furthermore, the protrusions 22b and 22c are disposed to stick into the insulating layer 21. The protrusion 22b is directed to be inclined toward the surface conductor layer 23 in this case. Otherwise, the protrusion 22b is directed to be inclined toward the top layer 25. In still other words, the protrusion 22b is inclined from a side surface of the via conductor 22 to be directed toward the surface conductor layer 23 or the top layer 25. The protrusion 22c is directed to be inclined toward the core substrate 10. In other words, the protrusion 22c is inclined from the side surface of the via conductor 22 to be directed toward the core substrate 10.

As illustrated in FIG. 1, the surface conductor layer 23 is stacked on the surface 21d of the insulating layer 21 on the side far from the core substrate 10. The surface conductor layer 23 constitutes a wiring pattern. The surface conductor layer 23 is electrically connected to the via conductor 22.

The surface conductor layer 23 may include the seed layer 24 and the top layer 25. The top layer 25 indicates a metal film included in the surface conductor layer 23 and positioned to allow the seed layer 24 to be interposed between the insulating layer 21 and the top layer 25. The top layer 25 corresponds to part of the metal film constituting the surface conductor layer 23. The seed layer 24 and the top layer 25 are disposed to be stacked in the mentioned order on the surface 21d of the insulating layer 21 on the side far from the core substrate 10. The seed layer 24 is exemplarily 2 µm or more and 17 µm or less in thickness. The seed layer 24 and the top layer 25 constitute a wiring pattern. The seed layer 24 and the top layer 25 are made of a conductive metal such as copper.

The seed layer 24 includes an opening 24a positioned to be overlapped with the hole 21a. The opening 24a includes an inner edge positioned to be overlapped with an open edge of the hole 21a or positioned outside the open edge of the hole 21a. The seed layer 24 includes a tapered portion 24b in a region around the opening 24a. The region around the opening 24a includes the inner edge (or an edge) of the opening 24a and expands in a normal direction from the inner edge to have a predetermined width. The tapered portion 24b is gradually decreased in thickness toward the edge of the opening 24a. In other words, the seed layer 24 is preferred to be gradually increased in thickness outward from the edge of the opening 24a in the normal direction. When the seed layer 24 is shaped to be gradually increased in thickness outward from the edge of the opening 24a in the normal direction, the tapered portion 24b of the seed layer 24 is less likely to be detached from the insulating layer 21. A plurality of members such as the insulating layer 21, the via conductor 22, and the top layer 25 is in contact with each other at a site near the tapered portion 24b of the seed layer 24. Stress is likely to be generated at the site where a plurality of members is in contact with each other due to differences in the thermal expansivity and the Young's modulus between the members. In such a case, the seed layer 24, which is shaped to be gradually increased in thickness outward from the edge of the opening 24a in the normal direction, can reduce stress that is likely to be generated around the edge of the opening 24a at an end of the tapered portion 24b. In this case, the seed layer 24 is particularly preferred to be decreased in thickness toward the edge of the opening 24a. Furthermore, the tapered portion 24b includes a surface that is in contact with the top layer 25 and that preferably has a curved shape to be convex toward the top layer 25. The top layer 25 is provided continuously to the via conductor 22 through the opening 24a so as to be integral with the via conductor 22. The top layer 25 includes a portion overlapped with the tapered portion 24b and gradually decreased in thickness toward the edge of the opening 24a. The tapered portion 24b at the edge of the opening 24a has an angle θ that exemplarily exceeds 45 degrees and that is more specifically preferred to be 50 degrees or more and 80 degrees or less.

The surface conductor layer 23 includes a portion overlapped with the via conductor 22 and functioning as a land having a diameter larger than a line width of the wiring pattern. The diameter of the land is preferably 200 µm or more and 250 µm or less.

As described above, the printed wiring board 1 may include the second buildup layer 50. The second buildup layer 50 is positioned on a surface of the core substrate 10 opposite to the surface provided with the first buildup layer 20. The core substrate 10 may include the conductor layer 13 provided on the surface in contact with the second buildup layer 50. The second buildup layer 50 includes an insulating layer 51, at least one via conductor 52, and a surface conductor layer 53. The second buildup layer 50 is provided identically or similarly to the first buildup layer 20. The insulating layer 51 of the second buildup layer 50 corresponds to the insulating layer 21 of the first buildup layer 20, the via conductor 52 of the second buildup layer 50 corresponds to the via conductor 22 of the first buildup layer 20, and the surface conductor layer 53 of the second buildup layer 50 corresponds to the surface conductor layer 23 of the first buildup layer 20. The insulating layer 51 includes a hole 51a corresponding to the hole 21a of the insulating layer 21, the surface conductor layer 53 includes a seed layer 54 corresponding to the seed layer 24 of the surface conductor layer 23, the surface conductor layer 53 includes a top layer 55 corresponding to the top layer 25 of the surface conductor layer 23, and the seed layer 54 includes an opening 54a corresponding to the opening 24a of the seed layer 24. Identically or similarly to the seed layer 24 including the tapered portion surrounding the opening 24a, the seed layer 54 includes a tapered portion surrounding the opening 54a and gradually decreased in thickness toward an edge of the opening.

### [1-3. Solder resist layer]

The solder resist layers 40 and 70 are stacked on respective surfaces of a stacked body including the first buildup layer 20, the core substrate 10, and the second buildup layer 50. That is, the first solder resist layer 40 covers the surface conductor layer 23 as well as the surface 21d of the insulating layer 21 on the side far from the core substrate 10. The second solder resist layer 70 covers the surface conductor layer 53 as well as a surface 51d of the insulating layer 51 on a side far from the core substrate 10.

The first solder resist layer 40 includes at least one opening 41. Part of the surface conductor layer 23 is overlapped with the opening 41, and the surface conductor layer 23 includes a portion positioned inside the opening 41 and functioning as a terminal. Identically or similarly to the first solder resist layer 40, the second solder resist layer 70 includes at least one opening 71. Part of the surface conductor layer 53 is overlapped with the opening 71, and the surface conductor layer 53 includes a portion positioned inside the opening 71 and functioning as a terminal.

### [1-4. Variations]

(1) FIG. 1 exemplarily illustrates a configuration including the single first buildup layer 20. In contrast, a plurality of first buildup layers 20 may be stacked between the core substrate 10 and the first solder resist layer 40. Identically or similarly, a plurality of second buildup layers 50 may be stacked between the core substrate 10 and the second solder resist layer 70.
   When the core substrate 10 is provided directly thereon with n layers of first buildup layers 20, the via conductor 22 in each of the second to n-th layers of the first buildup layers 20 is electrically connected to the surface conductor layer 23 in the first buildup layer 20 disposed immediately therebelow. The same or a similar applies to the via conductor 52 in each of n layers of second buildup layers 50.
(2) In exemplary illustration in FIG. 2, the via conductor 22 and the hole 21a each have a constant diameter in the thickness direction. As illustrated in FIG. 5, the hole 21a may alternatively include a portion that is close to the conductor layer 12 and that is tapered by being gradually decreased in diameter from the opening 24a toward the conductor layer 12. In this case, the via conductor 22 accordingly includes a portion that is close to the conductor layer 12 and that is gradually decreased in diameter from the opening 24a toward the conductor layer 12, and the portion 21e is tapered.

### [1-5. Conclusions]

(1) Conventionally when a via conductor is gradually decreased in diameter from a solder resist layer toward a core substrate to have a truncated cone shape, the via conductor is likely to be disengaged from an insulating layer. In contrast, the via conductors 22 and 52 each have a constant diameter in the thickness direction to have a columnar shape. In comparison to the conventional via conductor, the via conductors 22 and 52 are thus less likely to be disengaged from the insulating layers 21 and 51, respectively.
(2) The via conductor 22 having the constant diameter in the thickness direction contributes to improvement in the connection reliability between the via conductor 22 and the conductor layer 12. The via conductor 22 and the conductor layer 12 have a coupling area larger than a coupling area between the conventional via conductor and a conductor layer. Accordingly, the via conductor 22 is less likely to be separated from the conductor layer 12 whereas the conventional via conductor is likely to be separated from the conductor layer. Identically or similarly, the via conductor 52 has the constant diameter in the thickness direction and is thus less likely to be separated from the conductor layer 13.
(3) A difference in the thermal expansivity between the via conductor 22 and the insulating layer 21 may cause separation of the via conductor 22 from the conductor layer 12. Even in such a case, the via conductor 52 has the constant diameter in the thickness direction, and the via conductor 22 is thus less likely to be separated from the conductor layer 12.
(4) The via conductor 22 includes the bottom 22a having the convex surface shape, the conductor layer 12 includes the surface 12a having the concave surface shape, and the bottom 22a of the via conductor 22 is fitted to the surface 12a having the concave surface shape. This configuration contributes to improvement in the electrical characteristics between the via conductor 22 and the conductor layer 12. Specifically, this configuration increases the coupling area between the via conductor 22 and the conductor layer 12 to stabilize electric resistance, electric conductivity, and the like at around a boundary between the via conductor 22 and the conductor layer 12. The same or a similar applies to the via conductor 52 and the conductor layer 13.
(5) An outer circumference of the via conductor 22 and the inner wall surface of the hole 21a form a boundary surface having unevenness, so that the via conductor 22 and the insulating layer 21 achieve high intimate contact properties and high adhesive properties as well as the via conductor 22 is less likely to be disengaged from the insulating layer 21. The same or a similar applies to the via conductor 52 and the insulating layer 51.
(6) Unevenness on the outer circumference of the via conductor 22 includes the at least one protrusion 22b that is inclined toward the top layer 25 and that sticks from the hole 21a into the insulating layer 21. The protrusion 22b anchors the via conductor 22 to the insulating layer 21. Accordingly, the via conductor 22 is less likely to be disengaged from the hole 21a toward the top layer 25 as well as is less likely to be separated from the conductor layer 12. The same or a similar applies to the via conductor 52.
(7) The unevenness on the outer circumference of the via conductor 22 includes the at least one protrusion 22c that is inclined toward the core substrate 10 and that sticks from the hole 21a into the insulating layer 21. The protrusion 22c anchors the via conductor 22 to the insulating layer 21. Accordingly, the protrusion 22c improves anchoring effects in comparison to a configuration including only the protrusion 22b inclined toward the top layer 25, and the via conductor 22 is less likely to be separated from the top layer 25. The same or a similar applies to the via conductor 52.
(8) The seed layer 24 includes the tapered portion 24b surrounding the opening 24a, to increase a contact area between the seed layer 24 and the top layer 25 around the opening 24a in comparison to a case without the tapered portion 24b. This configuration is less likely to cause detachment of the top layer 25 from the seed layer 24 in the region around the opening 24a, so that the via conductor 22 is less likely to be disengaged from the insulating layer 21. The same or a similar applies to the via conductor 52.

### [2. Method of manufacturing printed wiring board]

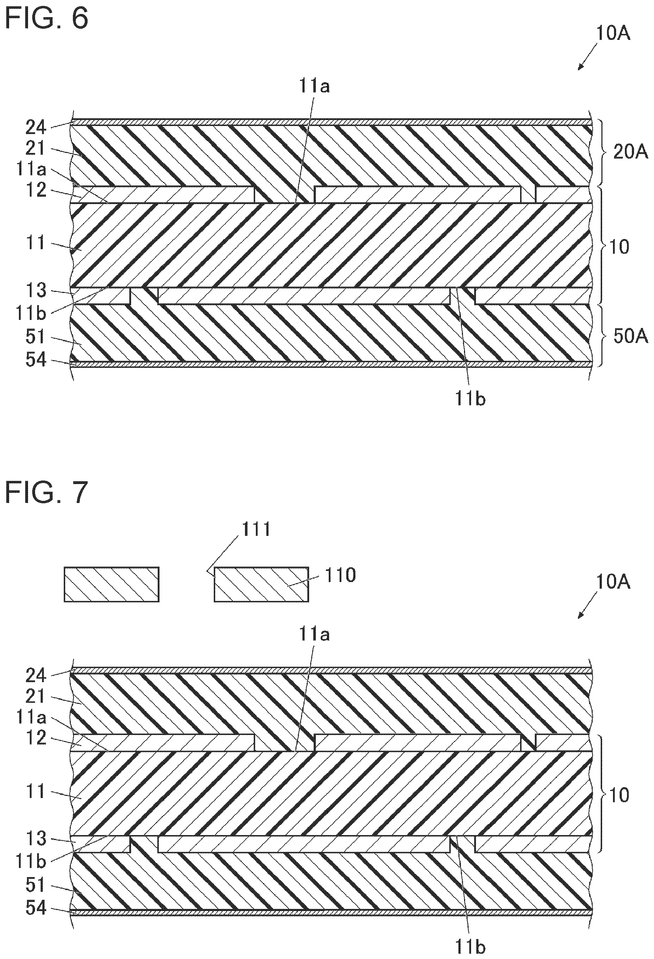

Description is made to a method of manufacturing the printed wiring board 1 with reference to FIGs. 6 to 13.

### [2-1. Preparations]

Initially prepared is a stacked body 10A. The stacked body 10A includes the core substrate 10 and a buildup precursor layer 20A stacked thereon. As necessary, a buildup precursor layer 50A may be stacked on the core substrate 10 such that the buildup precursor layers 50A and 20A oppose each other to interpose the core substrate 10. The stacked body 10A includes the seed layer 54, the insulating layer 51, the core substrate 10, the insulating layer 21, and the seed layer 24, which are disposed in the mentioned order as illustrated in FIG. 6. The buildup precursor layer 20A includes the insulating layer 21 and the seed layer 24. The buildup precursor layer 50A includes the insulating layer 51 and the seed layer 54. The seed layers 24 and 54 have not yet constituted any wiring pattern. The insulating layer 21 does not include the hole 21a, and the insulating layer 51 does not include the hole 51a. At this stage, the seed layers 24 and 54 are exemplarily 3 µm or more and 18 µm or less in thickness. The insulating layer 21 is exemplarily 40 µm to 100 µm in thickness.

The stacked body 10A is exemplarily prepared as in (1) or (2) described below.
(1) Prepreg, a resin film, or the like is stacked on each surface of the core substrate 10, and metal foil is further stacked on the prepreg, the resin film, or the like. The metal foil and the prepreg, the resin film, or the like, as well as the core substrate 10 are then heated and pressurized to allow the prepreg or the resin film to be cured and firmly fixed to the core substrate 10 and the metal foil, so as to obtain the insulating layers 21 and 51 and the seed layers 24 and 54.
(2) A buildup sheet, which includes a resin film or the like and metal foil preliminarily stacked thereon, is stacked on each surface of the core substrate 10. The buildup sheet and the core substrate 10 are then heated and pressurized to allow the resin film or the like to be cured and firmly fixed to the core substrate 10, so as to obtain the insulating layers 21 and 51.

### [2-2. Roughening]

Subsequently executed is roughing surfaces of the seed layers 24 and 54. Specifically, the surfaces of the seed layers 24 and 54 are etched. The surfaces of the seed layers 24 and 54 are thus roughened and blackened as well as the seed layers 24 and 54 are thinned. After such surface treatment, the seed layers 24 and 54 are exemplarily 2 µm or more and 17 µm or less in thickness.

### [2-3. First laser processing]

Subsequently as illustrated in FIG. 7, the stacked body 10A is set in a laser processing machine, and a mask 110 is set between a laser oscillator of the laser processing machine and the seed layer 24. The mask 110 includes at least one through-hole 111 having a circular shape and penetrating the mask 110. The through-hole 111 has a diameter exemplarily from 2 mm to 3 mm, and more specifically 2.4 mm.

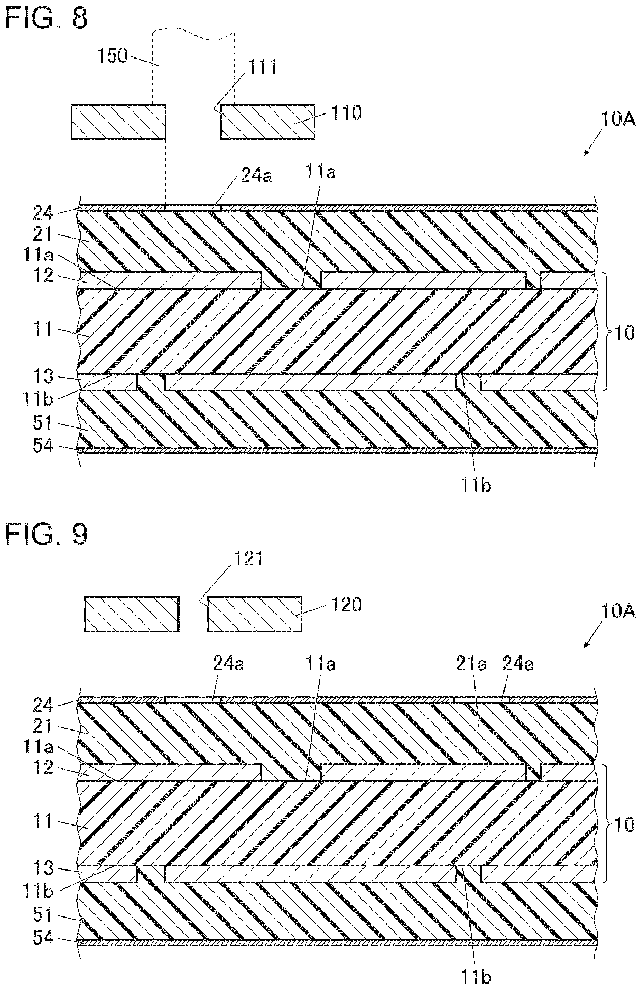

Subsequently as illustrated in FIG. 8, the laser processing machine is used to apply a laser beam 150 to the seed layer 24 through the through-hole 111. The seed layer 24 is provided with the opening 24a where the laser beam 150 is applied. The seed layer 24 has already been roughened as described above. The laser beam 150 is thus absorbed into the seed layer 24 without being reflected by the seed layer 24.

The laser processing machine has output of the laser beam 150 exemplarily 10 mJ/shot to 20 mJ/shot, and more specifically 16 mJ/shot. The opening 24a has a diameter determined in accordance with the diameter of the through-hole 111 and the output of the laser beam 150. The longer the diameter of the through-hole 111 is, the longer the diameter of the opening 24a is. The higher the output of the laser beam 150 is, the longer the diameter of the opening 24a is. When the diameter of the through-hole 111 is exemplarily 2.4 mm and the output of the laser beam 150 is exemplarily 16 mJ/shot, the opening 24a is formed to have 100 µm in diameter. The output of the laser beam 150 is also called power.

Application of the laser beam 150 is stopped when the laser beam 150 reaches a surface of the insulating layer 21.

In order to form a plurality of via conductors 22, a plurality of openings 24a is formed in the seed layer 24 by changing the application location of the laser beam 150.

### [2-4. Second laser processing]

Subsequently as illustrated in FIG. 9, the mask 110 is replaced with a mask 120 to be set. The mask 120 includes at least one through-hole 121 having a circular shape and penetrating the mask 120. The through-hole 121 is shorter in diameter than the through-hole 111 in the mask 110. The diameter of the through-hole 121 is exemplarily 1/3 or more and 1/2 or less the diameter of the through-hole 111, and more specifically 1.1 mm.

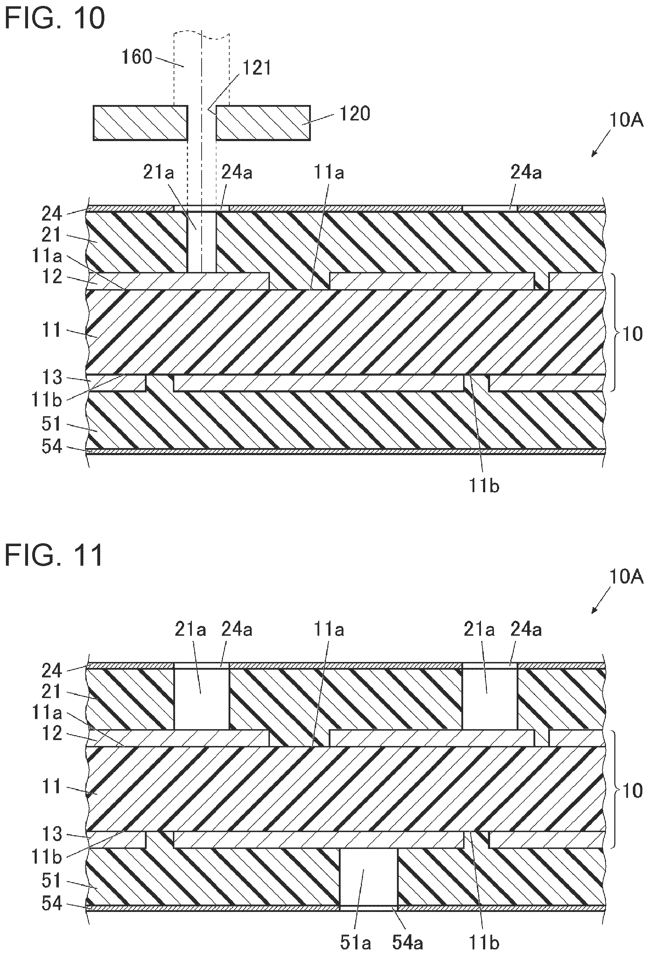

Subsequently as illustrated in FIG. 10, the laser processing machine is used to apply a laser beam 160 to the insulating layer 21 through the through-hole 121 and the opening 24a. The insulating layer 21 is thus provided with the circular hole 21a where the laser beam 160 is applied. Output of the laser beam 160 is exemplarily 1/15 or more and 1/8 or less the output of the laser beam 150 for formation of the opening 24a, and more specifically 1.8 mJ/shot. The hole 21a thus formed is shorter in diameter than the opening 24a. The diameter of the hole 21a is determined in accordance with the diameter of the through-hole 121 and the output of the laser beam 160. The longer the diameter of the through-hole 121 is, the longer the diameter of the hole 21a is. The higher the output of the laser beam 160 is, the longer the diameter of the hole 21a is. When the opening 24a is exemplarily formed under the above preferred conditions, the diameter of the through-hole 121 is 1.1 mm, and the output of the laser beam 160 is exemplarily 1.8 mJ/shot, the hole 21a is formed to have 80 µm in diameter.

Application of the laser beam 160 is stopped when the laser beam 160 reaches a surface of the conductor layer 12. The laser beam 160 is incident on the surface of the conductor layer 12 for a short period immediately before application of the laser beam 160 is stopped. The surface of the conductor layer 12 is thus formed into the concave surface shape by the laser beam 160.

In the above process of sequentially applying the laser beams 150 and 160 to the seed layer 24 and the insulating layer 21, the laser beam 150 is incident on the region around the opening 24a to form the tapered portion 24b in the region around the opening 24a.

In order to form a plurality of via conductors 22, a plurality of holes 21a is formed in the insulating layer 21 by changing the application location of the laser beam 160.

### [2-5. Processing opposite seed layer and insulating layer]

Identically or similarly to the opening 24a formed in the seed layer 24, the opening 54a is then formed in the seed layer 54. Identically or similarly to the hole 21a formed in the insulating layer 21, the hole 51a is subsequently formed in the insulating layer 51.

### [2-6. Desmearing]

Any smear in the holes 21a and 51a is then removed through plasma treatment, with use of an aqueous solution of permanganic acid, or the like. As illustrated in FIG. 11, such desmearing treatment increases the diameter of the hole 21a to be equal to the diameter of the opening 24a as well as increases the diameter of the hole 51a to be equal to the diameter of the opening 54a.

### [2-7. Plating]

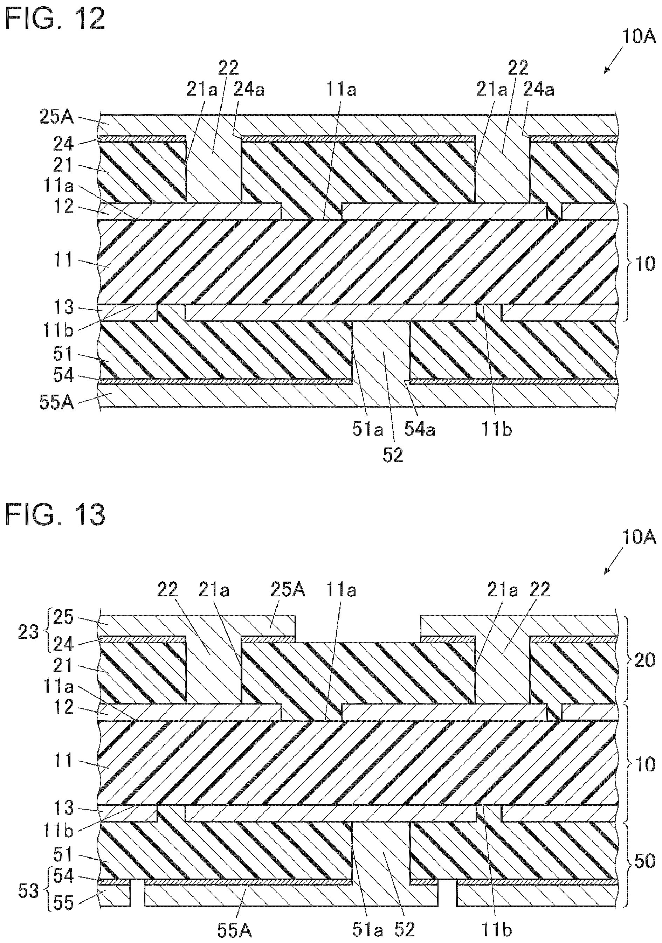

Plating treatment is subsequently applied to the stacked body 10A provided with the openings 24a and 54a and the holes 21a and 51a to obtain the via conductors 22 and 52 and metal plated layers 25A and 55A entirely on respective surfaces of the stacked body 10A as illustrated in FIG. 12.

### [2-8. Patterning]

As illustrated in FIG. 13, the metal plated layers 25A and 55A and the seed layers 24 and 54 are then provided with a wiring pattern.

Specifically, resist is initially stacked on each of the metal plated layers 25A and 55A. The resist is exposed to be developed. When the metal plated layers 25A and 55A and the seed layers 24 and 54 are etched with the resist functioning as a mask, the metal plated layers 25A and 55A and the seed layers 24 and 54 are formed to constitute a wiring pattern. The metal plated layer 25A still remaining corresponds to the top layer 25 constituting the wiring pattern, and the metal plated layer 55A still remaining corresponds to the top layer 55 constituting the wiring pattern.

### [2-9. Forming solder resist layer]

Subsequently, the first solder resist layer 40 is stacked on the insulating layer 21 and the top layer 25, and the second solder resist layer 70 is stacked on the insulating layer 51 and the top layer 55.

The printed wiring board 1 is completed through the above processes.

### [2-10. Variations]

(1) As described above, the wiring pattern on the seed layers 24 and 54 and the top layers 25 and 5 are formed through a subtractive process. The wiring pattern may alternatively be formed through a modified semi additive process (MSAP).
(2) When there are provided a plurality of first buildup layers 20 and a plurality of second buildup layers 50, an additional insulating layer 21 and an additional seed layer 24 are formed on the first buildup layer 20 already provided and an additional insulating layer 51 and an additional seed layer 54 are formed on the second buildup layer 50 already provided after the process of [2-8]. The processes of [2-4] to [2-8] are then applied to the additional insulating layers 21 and 51 and the additional seed layers 24 and 54. Such a series of processes are executed once or a plurality of times and the process of [2-9] is then executed.

### [2-11. Conclusions]

(1) The through-hole 121 allowing passage of the laser beam 160 is shorter in diameter than the through-hole 111. The hole 21a formed by the laser beam 160 is thus shorter in diameter than the opening 24a formed by the laser beam 150. The hole 21a having been formed includes an inner wall that may be increased in diameter through the desmearing treatment, and the hole 21a and the opening 24a are thus highly possibly approximated or equalized in diameter. In this case, the output of the laser beam 160 is preferably set to 1/5 to 1/100 of the output of the laser beam 150. The seed layer 24 can then come into a state not bulging inward from the edge of the hole 21a. This promotes circulation of a plating solution in the hole 21a. A plated metal preferably grows in the hole 21a and the via conductor 22 is preferably formed. That is, the via conductor 22 is less likely to include any void, defect, or the like. The same or a similar applies to the via conductor 52. The via conductors 22 and 52 are likely to include fine metal crystals formed on the inner wall of the hole 21a, and are likely to be buried in the unevenness on the inner wall of the hole 21a. Furthermore, the metal crystals are likely to constitute a crystalline structure including a regulated kink structure with a fewer defects from around the inner wall of the hole 21a to central axes of the via conductors 22 and 52.
(2) Under the above output conditions of the laser beam 160, the hole 21a is less likely to be increased in diameter by the laser beam 160 while the laser beam 160 is being applied to extend the hole 21a toward the conductor layer 12. Accordingly, the hole 21a has an opening size at a site distant from the seed layer 24 substantially equal to an opening size at a site close to the seed layer 24. The hole 21a is formed to have a constant diameter in the thickness direction even after the desmearing treatment, and the via conductor 22 is formed to have a constant diameter in the thickness direction. The via conductor 22 is thus less likely to be disengaged from the insulating layer 21 as well as can have a larger contact area with the conductor layer 12 in comparison to a conductor filled in a hole having a tapered shape. The same or a similar applies to the via conductor 52.
(3) A plated material is typically less likely to adhere to a liquid crystal polymer and a polytetrafluoroethylene resin. Even when the insulating layer 21 is made of the liquid crystal polymer or the polytetrafluoroethylene resin, the above manufacturing method achieves the via conductor 22 that is less likely to be disengaged from the insulating layer 21.
(4) The diameter of the through-hole 121 allowing passage of the laser beam 160 is 1/3 or more and 1/2 or less the diameter of the through-hole 111 allowing passage of the laser beam 150. The output of the laser beam 160 is 1/15 or more and 1/8 or less the output of the laser beam 150 for formation of the opening 24a. Even with the insulating layer 21 having 40 µm to 100 µm in thickness, the hole 21a can achieve 5 µm or less as a difference between the opening size at the site close to the seed layer 24 and the opening size at the site distant from the seed layer 24.
(5) The hole 21a and the via conductor 22 are formed to have the constant diameters in the thickness direction. The via conductor 22 can thus have a smaller diameter in the portion close to the seed layer 24 when the opening size of the hole 21a at the site distant from the seed layer 24 is equal to an opening size at a bottom of a tapered hole. The land overlapped with the via conductor 22 can accordingly be decreased in diameter. When a plurality of via conductors 22 is provided, the via conductors 22 can have a shorter pitch therebetween. Even when lands are 225 µm or more and 250 µm or less in diameter and the pitch between the via conductors 22 is 245 µm, this configuration secures insulation characteristics between the lands and insulation characteristics between the via conductors 22.
(6) The opening 24a is formed in the seed layer 24 without through complicated etching treatment. Formation of the opening 24a in the seed layer 24 can thus be simplified in comparison to any other method such as a large window method or a conformal mask method. The large window method includes etching copper foil to form an opening and then applying laser beam machining to a resin layer to form a hole smaller in diameter than the opening. The conformal mask method includes etching copper foil to form an opening and then applying laser beam machining to a resin layer to eventually form a hole larger in diameter than the opening.
(7) Each of the laser beams 150 and 160 is applied with use of the identical laser processing machine. The above manufacturing method thus includes a smaller number of processes.

### [3. Others]

Specific details such as the configurations, structures, positional relationships, and shapes exemplified in the embodiment described above are changeable as appropriate without departing from the purport of the present disclosure. Furthermore, any of the configurations, structures, positional relationships, and shapes exemplified in the above embodiment can be combined as appropriate without departing from the purport of the present disclosure.

In an embodiment, (1) a printed wiring board includes a core substrate and a buildup layer stacked on the core substrate. The buildup layer includes an insulating layer stacked on the core substrate, a hole penetrating the insulating layer in a thickness direction, and a via conductor filled in the hole. The via conductor has a columnar shape.

(2) In the printed wiring board according to (1) described above, the hole includes an inner wall surface having unevenness. The via conductor is in contact with the inner wall surface.

(3) In the printed wiring board according to (1) or (2) described above, the buildup layer includes a surface conductor layer disposed on the insulating layer on a side far from the core substrate. The via conductor includes a side surface directed toward an inner wall surface of the hole. The side surface includes at least one protrusion. The protrusion is inclined to be directed toward the surface conductor layer.

(4) In the printed wiring board according to (3) described above, the protrusion is inclined to be directed toward the core substrate.

(5) In the printed wiring board according to (3) or (4) described above, the surface conductor layer includes a seed layer and a top layer. The seed layer is positioned adjacent to the insulating layer, and includes an opening positioned to be overlapped with the via conductor. The opening includes an inner edge positioned to be overlapped with an open edge of the hole or positioned outside the open edge of the hole.

(6) In the printed wiring board according to (5) described above, the inner edge of the opening defines a region including a tapered portion gradually decreased in thickness toward the open edge.

(7) In the printed wiring board according to any one of (1) to (6) described above, the core substrate includes a conductor layer on a surface in contact with the buildup layer. The conductor layer includes a portion being in contact with the via conductor and having a concave surface shape.

In an embodiment, (8) a method of manufacturing a printed wiring board includes: preparing a stacked body including a core substrate and a buildup precursor layer that includes an insulating layer and a seed layer made of a metal in a mentioned order and that is overlapped with the core substrate; disposing, above and adjacent to the seed layer in the stacked body, a first mask including a first through-hole, and applying a first laser beam to the seed layer through the first through-hole to form an opening in the seed layer; disposing, on the seed layer at a position above the first through-hole, a second mask including a second through-hole smaller in diameter than the first through-hole, and applying a second laser beam to the insulating layer through the opening to form a hole in the insulating layer; and applying plating treatment to the insulating layer provided with the hole to grow a plated film on the seed layer and the hole and form a via conductor and a top layer.

(9) In the manufacturing method according to (8) described above, the second through-hole is 1/3 or more and 1/2 or less the first through-hole in diameter.

(10) In the manufacturing method according to (8) or (9) described above, output of the second laser beam is 1/15 or more and 1/8 or less output of the first laser beam.

(11) As to the manufacturing method according to any one of (8) to (10) described above, the method further includes increasing a diameter of the hole so as not to exceed an inner edge of the opening in the seed layer.

### REFERENCE SIGNS

10 core substrate
10A stacked body
20 first buildup layer
20A buildup precursor layer
21 insulating layer
21a hole
22 via conductor
22b protrusion
22c protrusion
24 seed layer
24a opening
24b tapered portion
25 top layer
50 second buildup layer
50A buildup precursor layer
51 insulating layer
51a hole
52 via conductor
54 seed layer
54a opening
55 top layer

## Claims

1. A printed wiring board comprising:
a core substrate; and
a buildup layer stacked on the core substrate; wherein
the buildup layer includes
an insulating layer stacked on the core substrate,
a hole penetrating the insulating layer in a thickness direction, and
a via conductor filled in the hole, and
the via conductor has a columnar shape.

2. The printed wiring board according to claim 1, wherein
the hole includes an inner wall surface having unevenness, and
the via conductor is in contact with the inner wall surface.

3. The printed wiring board according to claim 1 or 2, wherein
the buildup layer includes a surface conductor layer disposed on the insulating layer on a side far from the core substrate,
the via conductor includes a side surface directed toward an inner wall surface of the hole,
the side surface includes at least one protrusion, and
the protrusion is inclined to be directed toward the surface conductor layer.

4. The printed wiring board according to claim 3, wherein
the protrusion is inclined to be directed toward the core substrate.

5. The printed wiring board according to claim 3 or 4, wherein
the surface conductor layer includes a seed layer and a top layer,
the seed layer is positioned adjacent to the insulating layer, and includes an opening positioned to be overlapped with the via conductor, and
the opening includes an inner edge positioned to be overlapped with an open edge of the hole or positioned outside the open edge of the hole.

6. The printed wiring board according to claim 5, wherein the inner edge of the opening defines a region including a tapered portion gradually decreased in thickness toward the open edge.

7. The printed wiring board according to any one of claims 1 to 6, wherein the core substrate includes a conductor layer on a surface in contact with the buildup layer, and the conductor layer includes a portion being in contact with the via conductor and having a concave surface shape.

8. A method of manufacturing a printed wiring board, the method comprising:
preparing a stacked body including a core substrate and a buildup precursor layer that includes an insulating layer and a seed layer made of a metal in a mentioned order and that is overlapped with the core substrate;
disposing, above and adjacent to the seed layer in the stacked body, a first mask including a first through-hole, and applying a first laser beam to the seed layer through the first through-hole to form an opening in the seed layer;
disposing, on the seed layer at a position above the first through-hole, a second mask including a second through-hole smaller in diameter than the first through-hole, and applying a second laser beam to the insulating layer through the opening to form a hole in the insulating layer; and
applying plating treatment to the insulating layer provided with the hole to grow a plated film on the seed layer and the hole and form a via conductor and a top layer.

9. The method of manufacturing the printed wiring board according to claim 8, wherein the second through-hole is 1/3 or more and 1/2 or less the first through-hole in diameter.

10. The method of manufacturing the printed wiring board according to claim 8 or 9, wherein output of the second laser beam is 1/15 or more and 1/8 or less output of the first laser beam.

11. The method of manufacturing the printed wiring board according to any one of claims 8 to 10, the method further comprising increasing a diameter of the hole that includes an open edge not exceeding an inner edge of the opening in the seed layer.
